# EUROPÄISCHE PATENTSCHRIFT

(11) **EP 1 319 268 B1**
(45) Veröffentlichungstag und Bekanntmachung des Hinweises auf die Patenterteilung: **24.03.2004**
(21) Anmeldenummer: 01967056.1
(22) Anmeldetag: 31.08.2001
(51) Int. Cl.: H03J 1/00, H03J 7/04

(54) **VERFAHREN ZUR KALIBRIERUNG DER FREQUENZ EINES HF-OSZILLATORS IN EINEM MOBILTEIL EINER MOBILEN KOMMUNIKATIONSEINRICHTUNG**
METHOD FOR CALIBRATING THE FREQUENCY OF AN HF-OSCILLATOR IN A MOBILE PART OF A MOBILE COMMUNICATIONS DEVICE
PROCEDE DE CALIBRAGE DE LA FREQUENCE D'UN OSCILLATEUR HF DANS UN ELEMENT MOBILE D'UN DISPOSITIF DE COMMUNICATION MOBILE

(30) Priorität: 20.09.2000 DE 10046574
(43) Veröffentlichungstag der Anmeldung: 18.06.2003
(73) Patentinhaber: SIEMENS AKTIENGESELLSCHAFT, 80333 München (DE)
(72) Erfinder: BIENEK, Bernd, 46395 Bocholt (DE); FALKENBERG, Andreas, Escondido, CA 92026 (US); KARGER, Stephan, 46499 Hamminkeln (DE); KREUL, Theo, 46325 Borken (DE); KUNZ, Albrecht, 66121 Saarbrücken (DE); LANDENBERGER, Holger, 46395 Bocholt (DE)
(86) Internationale Anmeldenummer: PCT/DE2001/003341
(87) Internationale Veröffentlichungsnummer: WO 2002/025812

(56) Entgegenhaltungen:
- EP-A- 0 735 675
- EP-A- 0 845 860
- US-A- 5 276 706
- US-A- 5 649 320

## Beschreibung

Verfahren zur Kalibrierung der Frequenz eines HF-Oszillators in einem Mobilteil einer mobilen Kommunikationseinrichtung

Die Erfindung bezieht sich auf ein Verfahren zur Kalibrierung der Frequenz eines HF-Oszillators nach dem Oberbegriff des Anspruchs 1. Ein derartiges Verfahren ist aus der EP-A-0 845 860 bekannt.

Ein ähnliches Verfahren ist aus der EP 0 735 675 A2 bekannt, wobei die Ermittlung des Sequenzfehlers sukzessive dadurch erfolgt, dass ein Suchbereich für die Frequenz der Basisstation erweitert wird, bis die Frequenz der Basisstation gefunden ist. Die Kanalfrequenz der Basisstation ist zwar grundsätzlich, jedoch nicht auf Seiten der mobilen Kommunikationseinrichtung bekannt.

Allgemein gibt es im Bereich der mobilen Kommunikation je nach Übertragungsverfahren einen gewissen Standard, der für eine Basisstation einer Kommunikationseinrichtung eine vorgegebene Frequenzgenauigkeit beim Senden fordert und über weitere Systemeigenschaften eine Frequenzgenauigkeit für den Empfangsfall im mobilen Empfängerteil vorschreibt.

Bisher wurde dieser Standard dadurch gewährleistet, dass während der Fertigung des Mobilteils einer mobilen Kommunikationseinrichtung eine Kalibrierung des HF-Oszillators erfolgte. Eine Kalibrierung in der Fertigung ist jedoch sehr aufwendig und benötigt eine lange Produktionszeit.

Zur Korrektur der Temperaturabhängigkeit eines HF-Oszillators in einem Mobilteil einer mobilen Kommunikationseinrichtung wurde es auch schon vorgeschlagen, einen Temperatursensor zu verwenden, der in Verbindung mit einem entsprechenden Algorithmus den temperaturabhängigen Fehler des HF-Oszillators kompensiert. Auch diese Methode ist sehr aufwendig.

Aufgabe der vorliegenden Erfindung ist es deshalb, ein Verfahren vorzustellen, durch das die Produktionskosten für eine mobile Kommunikationseinrichtung gesenkt werden und gleichzeitig eine zuverlässige Kalibrierung der Frequenz des HF-Oszillators des Mobilteils der mobilen Kommunikationseinrichtung gewährleistet ist.

Die Aufgabe wird durch ein Verfahren mit den Merkmalen des Anspruchs 1 gelöst. Weiterbildungen der Erfindung sind Gegenstand der Unteransprüche.

Die Erfindung beruht auf dem Grundgedanken, dass die Kalibrierung des HF-Oszillators beim erstmaligen Einschalten eines mobilen Empfangsgerätes durch den Kunden erfolgen kann. Dazu wird die mit einer ausreichend hohen Genauigkeit und durch Standardisierungsgremien spezifizierte Genauigkeit der Sendefrequenz einer Basisstation verwendet. Der gesendete Träger mit darauf modulierter Information, der von der Basisstation gesendet wird, wird im mobilen Empfangsteil mittels eines Suchalgorithmus abgetastet. Wird der gesendete Träger, dessen Frequenz durch das Kanalraster a priori mit hoher Genauigkeit bekannt ist, mit der aufmodulierten Information mit einer ausreichenden Frequenzgenauigkeit empfangen, so kann der Frequenzfehler ermittelt werden und der Mobilteil der mobilen Kommunikationseinrichtung auf diesen Träger synchronisiert werden. Die um den Frequenzfehler korrigierte Frequenz wird dann als Referenzfrequenz verwendet. Anstelle der Erstkalibrierung während des Produktionsprozesses des Mobilteils, werden die benötigten Einstellungen beim ersten Inbetriebnehmen mittels des Frequenzsuchalgorithmus vorgenommen. Das Kalibrieren erfolgt somit vollautomatisch.

Vorteilhaft ist es, das erfindungsgemäße Verfahren wiederholt durchzuführen, insbesondere bei jedem x-ten Verbindungsaufbau, wobei jeweils von der zuletzt ermittelten Referenzfrequenz ausgegangen wird. Bei diesen späteren Aufsynchronisierungsvorgängen kann dann von einer geringeren Frequenzabweichung des HF-Oszillators ausgegangen werden. In der Regel wird das erfindungsgemäße Verfahren nicht gleich wieder durchgeführt, da davon ausgegangen werden kann, dass durch die vorherige Autoinitialkalibrierungder HF-Oszillator gut kalibriert wurde. Der Platzhalter x hängt unter anderem von Temperaturschwankungen der Umgebung des Oszillators und seinem Alter ab. Der Platzhalter x kann demnach zwar 1 sein, muss dies aber nicht zwingend sein. Damit wird das künftige Aufsynchronisieren beschleunigt. Des weiteren wird die Genauigkeit durch Mittelung mehrerer Messungen erhöht. Außerdem wird die Schnelligkeit des Aufsynchronisierens dadurch erhöht, dass nur ein kleinerer Frequenzbereich abgetastet werden muss. Durch ein schnelleres Aufsynchronisieren wird der Stromverbrauch im Mobilteil verringert, was zu einer längeren Einsatzdauer desselben führt. Außerdem ist es dadurch möglich, Alterungseffekte und Temperaturabweichungen der Bauteile, die zur Frequenzerzeugung benötigt werden, nachzukalibrieren. Dies kann beispielsweise bei jedem x-ten Verbindungsaufbau stattfinden und verursacht demnach keinen zusätzlichen Mehraufwand. Durch die Nachkalibrierung wird auch die Produktlebensdauer ohne zusätzlichen Mehraufwand beträchtlich erhöht.

Vorteilhaft ist es auch, wenn beim erstmaligen Aufsynchronisieren ein gesendetes Signal einer beliebigen Basisstation mit ausreichender Genauigkeit verwendet wird, der anschließende Verbindungsaufbau jedoch auf einem Träger einer anderen Basisstation erfolgt. Dieses Signal kann ein besseres Signal-Rauschverhältnis aufweisen und eine höhere Frequenzgenauigkeit sowie eine kürzere Synchronisationszeit liefern. Beispielsweise ist es beim UMTS-Verfahren möglich, jeden der möglichen Kanäle des UMTS-Netzes zur Autokalibrierung heranzuziehen. Dadurch kann auf einen beliebigen Kanal einer bestimmten Basisstation eines Netzbetreibers aufsynchronisiert werden. Der anschließende Verbindungsaufbau kann dann auf einem beliebigen Kanal, auch einem anderen, bei einem anderen Netzbetreiber stattfinden. Ebenso ist es möglich, das Aufsynchronisieren und den Verbindungsaufbau mit der selben Basisstation durchzuführen, wenn diese die zur Zeit am besten geeignete ist.

Weiterhin kann bei einer vorteilhaften Weiterbildung der Erfindung mittels eines einzigen Multimode-Mobilteils die Synchronisation der mobilen Kommunikationseinrichtung mit untereinander synchronisierten Basisstationen unterschiedlicher Standards erfolgen. Dies führt zu einer einfachen, schnellen und vielseitig einsetzbaren Aufsynchronisation. Außerdem können dadurch viele verschiedene Standards miteinander verbunden werden.

Weiterhin ist vorteilhaft, wenn die Kalibrierung zusätzlich über den Temperaturbereich stattfindet, wozu eine Temperaturmessung mit dem Frequenzsuchalgorhythmus kombiniert wird. Eine solche Kalibrierung über die Temperatur wäre in der Fertigung besonders zeit- und kostenintensiv. Durch die ständige Veränderung der Umgebung des Mobilteiles kann durch eine solche Kalibrierung während der Frequenzakquisition eine ständige und optimale Anpassung an die aktuellen Gegebenheiten erfolgen.

Die Erfindung wird im Folgenden anhand eines bevorzugten Ausführungsbeispiels näher beschrieben, zu dessen Erläuterungen die nachstehend aufgelisteten Figuren dienen. Es zeigen:
- Figur 1: systematische Darstellung eines erfindungsgemäßen-Verfahrens und
- Figur 2: Simulationsergebnis durch das in Fig. 1 dargestellte Verfahren.

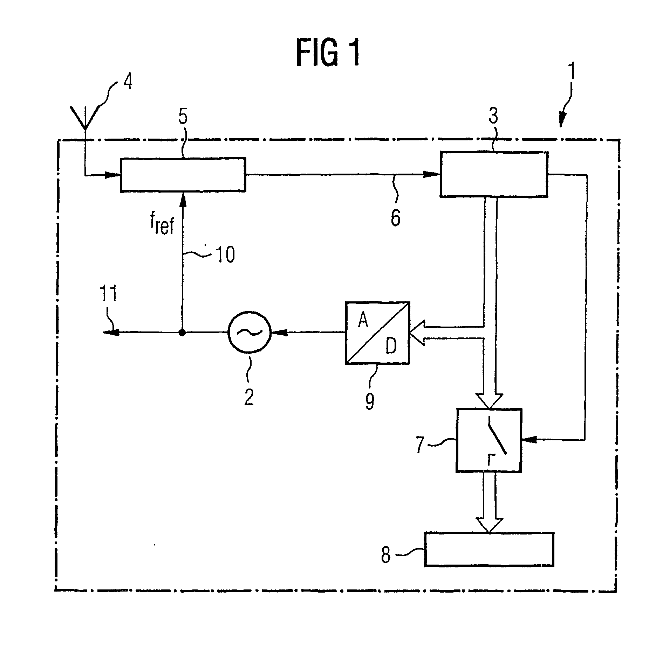

Das in **Fig. 1** dargestellte Verfahren wird beispielhaft anhand einer Anwendung im UMTS-Standard erläutert. Bei UMTS ist eine Sychnonisierung auf +/-3 ppm Genauigkeit hinsichtlich der verwendeten Trägerfrequenz erforderlich, um eine nachfolgende zeitliche Synchronisation vornehmen zu können. Ein HF-Oszillator einer Serie einer Produktion weist durchschnittlich eine Bauteilstreuung in der Eigenfrequenz von typischerweise +/-25 ppm auf. Diese wird dann durch die im folgenden beschriebene Autofrequenzkalibrierung auf eine Eigenfrequenzstreuung von +/-3 ppm reduziert. Von einem Mobilteil 1 einer mobilen Kommunikationseinrichtung wird ein, von einer nicht dargestellten Basisstation gesendetes Signal 4 in einem Empfänger 5 empfangen. Das gesendete Signal 4 ist aus dem Basisband der Basisstation, das um ca. 2,1 GHz herum angeordnet ist. Das empfangene Signal 4 wird mittels bekannter Mittel demoduliert und das so demodulierte Signal 6 in einem Auswerte- und Synchronisationsprogramm 3 mittels eines Korrelators mit der vorab schon bekannten und netzweit einheitlichen pSCH-Sequenz verglichen. Dabei steht pSCH für Primary Synchronisation Channel gemäß UMTS-Standard.

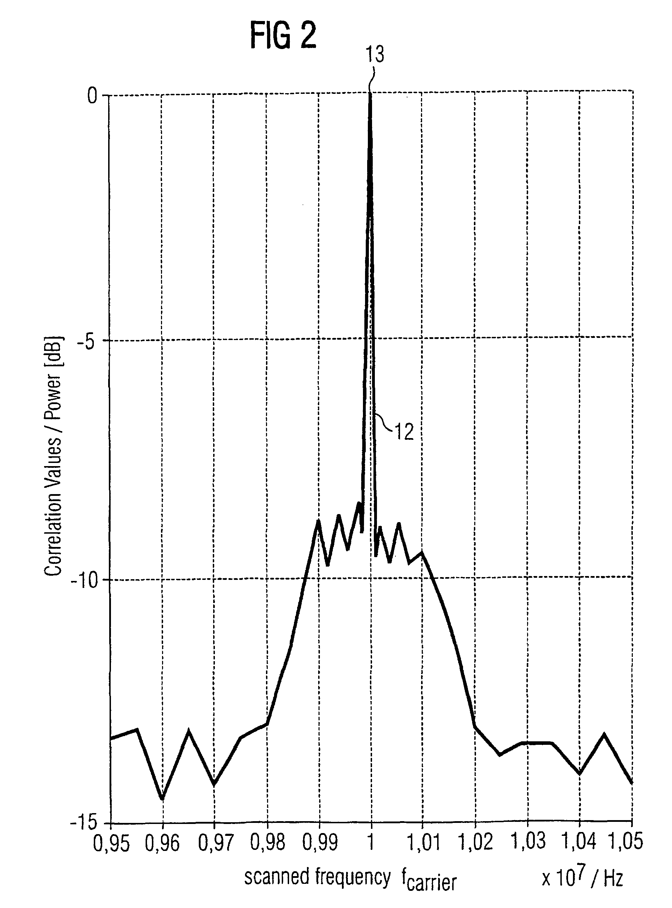

Die **Fig. 2** zeigt den Output 12 des Korrelators im Basisband, wobei die dargestellten Frequenzen um die Mitten-Trägerfrequenz der Basisstation reduziert sind. Bei einer Frequenz von 10 MHz ist eine Korrelationsspitze 13 ausgebildet. Der Mobilstation ist a priori bekannt, in welchem Kanalraster die Basisstation sendet. Die Trägerfrequenz kann basisstationseitig durch die Unterstützung von Funksignalen, wie beispielsweise DCF77 oder GPS mit einer Genauigkeit, die noch unterhalb der von der Spezifikation des UTMS-Standards von 0,05 ppm liegt. Aus dem Vergleich der bekannten Kanalfrequenz der Basisstation mit der gemessenen Korrelationsspitze 13 des Outputs 12 der Fig. 2 kann die Abweichung des HF-Oszillators 2 der Mobilstation 1 ermittelt werden. Hieraus werden die Daten für die Autokalibrierung gewonnen. Die produktionsbedingten Streuungen in der Oszillatoreigenfrequenz des HF-Oszillators 2 von +/-25 ppm können dadurch insoweit ausgeglichen werden, dass für künftige Synchronisationsvorgänge von einer maximalen Abweichung von +/-3 ppm ausgegangen werden kann. Dadurch werden künftige Synchronisationsprozesse wesentlich beschleunigt. Somit wird Zeit eingespart und die zur Kalibrierung benötigte Energie reduziert, was den Stromverbrauch reduziert und somit höhere stand-by-Zeiten des Mobilteils ermöglicht.

Durch den in Fig. 1 dargestellten Schritt des Vergleichs im Auswerte- und Synchronisationsprogramm 3 werden digitale Einstellungen gewonnen. Bei einer Synchronisation werden die Einstellungen über einen Schalter 7 an einen Speicher 8 weitergegeben, in dem diese abgelegt werden. Außerdem werden die digitalen Einstellungen an einen Digital-Analog-Wandler 9 weitergegeben. Dieser gibt das analoge Signal, das den digitalen Einstellungen entspricht, an den spannungsgesteuerten HF-Oszillator 2 weiter. Zum einen werden die digitalen Einstellungen zu weiteren Modulen 11 weitergegeben und zum anderen als neue Referenzfrequenz f_{ref} über eine Leitung 10 an den Empfänger 5 weitergegeben.

Diese neue Referenzfrequenz f_{ref} dient bei der nächsten Kalibrierung als Vergleichssignal für das dann empfangene, von der Basisstation gesendete Signal 4. Nach der Demodulation des vom Empfänger 5 weitergeleiteten demodulierten empfangenen Signals 6 zum Auswerte- und Synchronisationsprogramm 3 wird eine neue Kalibrierung mit den oben ausgeführten Schritten vorgenommen. Wobei nun das Aufsynchronisieren schneller erfolgen kann, da die jetzige Referenzfrequenz f_{ref} mit einem geringeren Streuwert behaftet ist.

## Patentansprüche

1. Verfahren zur Kalibrierung der Frequenz eines HF-Oszillators (2) in einem Mobilteil (1) einer mobilen Kommunikationseinrichtung beim erstmaligen Einschalten des Mobilteils (1) der mobilen Kommunikationseinrichtung mit folgenden Schritten:
a) Abtasten eines modulierten Trägers, der von einer Basisstation gesendet wird und eine vorgegebene Frequenzgenauigkeit aufweist,
b) Ermitteln des Frequenzfehlers zwischen der Frequenz des HF-Oszillators (2) in dem Mobilteil (1) der mobilen Kommunikationseinrichtung und einer bekannten Kanalfrequenz der Basisstation, wobei die um den Frequenzfehler korrigierte Frequenz für den HF-Oszillator (2) als Referenzfrequenz (f_{ref}) für weitere Kalibrierungsvorgänge übernommen wird,
c) Synchronisation der mobilen Kommunikationseinrichtung auf den modulierten Träger,
**dadurch gekennzeichnet, dass**
in Schritt a) das Abtasten des modulierten Trägers mittels eines Frequenzsuchalgorithmus erfolgt, bei dem der modulierte Träger demoduliert, wird, das so demodulierte Signal (6) in einem Auswerte- und Synchronisationsprogramm (3) mittels eines Korrelators mit einer vorab bekannten Sequenz verglichen wird und eine Korrelationspitze (13) im Output (12) des Korrelators bestimmt wird, und dass
in Schritt b) der Frequenzfehler durch Vergleich der gemessenen Korrelationsspitze (13) des Outputs (12) mit einem der mobilen Kommunikationseinrichtung vorab bekannten Kanalraster der Basisstation ermittelt wird.

2. Verfahren nach Anspruch 1,
**dadurch gekennzeichnet, dass**
das Verfahren unter dem UMTS-Standard durchgeführt wird und die Sequenz die netzwerkeinheitliche pSCH-Sequenz ist.

3. Verfahren nach Anspruch 1 oder 2,
**dadurch gekennzeichnet, dass**
dieses Verfahren wiederholt durchgeführt wird, insbesondere bei jedem x-ten Verbindungsaufbau, wobei jeweils von der zuletzt ermittelten Referenzfrequenz (f_{ref}) ausgegangen wird.

4. Verfahren nach einem der vorstehenden Ansprüche,
**dadurch gekennzeichnet, dass**
bei der erstmaligen Synchronisation ein gesendetes. Signal (4) einer beliebigen Basisstation verwendet wird, der anschließende Verbindungsaufbau jedoch auf einem Träger einer anderen Basisstation erfolgt.

5. Verfahren nach Anspruch 4,
**dadurch gekennzeichnet, dass**
ein einziges multimode-Mobilteil zur Synchronisation der mobilen Kommunikationseinrichtung mit untereinander synchronisierten Basisstationen unterschiedlicher Standards verwendet wird.

6. Verfahren nach einem der vorstehenden.Ansprüche,
**dadurch gekennzeichnet, dass**
mittels einer Temperaturmessung zusätzlich eine Kalibrierung über den Temperaturbereich erfolgt.

## Claims

1. Method for calibrating the frequency of an RF oscillator (2) in a mobile part (1) of a mobile communications device when the mobile part (1) of the mobile communications device is first switched on, having the following steps:
a) sampling a modulated carrier that is transmitted by a base station and has a prescribed frequency accuracy,
b) determining the frequency error between the frequency of the RF oscillator (2) in the mobile part (1) of the mobile communications device and a known channel frequency of the base station, the frequency, corrected by the frequency error, for the RF oscillator (2) being adopted as reference frequency (f_{ref}) for further calibration operations, and
c) synchronization of the mobile communications device with the modulated carrier,
**characterized in that**
in step a) the scanning of the modulated carrier is performed by means of a frequency search algorithm in the case of which the modulated carrier is demodulated, the signal (6) thus demodulated is compared in an evaluation and synchronization program (3) by means of a correlator with a sequence known in advance, and a correlation peak (13) in the output (12) of the correlator is determined, and **in that**
in step b) the frequency error is determined by comparing the measured correlation peak (13) of the output (12) with a channel raster, known in advance to the mobile communications device, of the base station.

2. Method according to Claim 1, **characterized in that** the method is carried out under the UMTS Standard, and the sequence is the pSCH sequence uniform throughout the network.

3. Method according to Claim 1 or 2, **characterized in that** this method is carried out repeatedly, in particular with each xth callup, starting in each case from the reference frequency (f_{ref}) last determined.

4. Method according to one of the preceding claims, **characterized in that** use is made during the first synchronization of a transmitted signal (4) of an arbitrary base station, but the subsequent callup is performed on a carrier of another base station.

5. Method according to Claim 4, **characterized in that** a single multimode mobile part is used for synchronizing the mobile communications device with mutually synchronized base stations of different standards.

6. Method according to one of the preceding claims, **characterized in that** a calibration is additionally performed over the temperature range by means of a temperature measurement.

## Revendications

1. Procédé de calibrage de la fréquence d'un oscillateur (2) HF d'un élément (1) mobile d'un dispositif de communication mobile lors du premier branchement de l'élément (1) mobile du dispositif de communication mobile, comprenant les stades suivants :
a) échantillonnage d'une porteuse modulée qui est émise par une station de base et qui a une précision de fréquence donnée à l'avance,
b) détermination de l'erreur de fréquence entre la fréquence de l'oscillateur (2) HF de l'élément (1) mobile du dispositif de communication mobile et une fréquence de canal connue du poste de base, dans lequel la fréquence, corrigée de l'erreur de fréquence de l'oscillateur (2) HF, est prise comme fréquence (f_{ref}) de référence pour d'autres opérations de calibrage,
c) synchronisation du dispositif de communication mobile sur la porteuse modulée,
**caractérisé en ce que**
au stade a) on effectue l'échantillonnage de la porteuse modulée au moyen d'un algorithme de recherche de fréquence, dans lequel on démodule la porteuse modulée, on compare le signal (6) ainsi démodulé dans un programme (3) d'évaluation et de synchronisation au moyen d'un corrélateur à une séquence connue au préalable et on détermine une pointe (13) de corrélation à la sortie (12) du corrélateur, et **en ce que**
au stade b) on détermine l'erreur de fréquence en comparant la pointe (13) mesurée de corrélation de la sortie (12) à une trame de canal de la station de base, connue auparavant, du dispositif de communication mobile.

2. Procédé suivant la revendication 1,
**caractérisé en ce que** l'on effectue le procédé dans le standard UMTS et la séquence est la séquence pSCH unifiée du réseau.

3. Procédé suivant la revendication 1 ou 2,
**caractérisé en ce que** l'on effectue ce procédé de manière répétée, notamment à chaque établissement de connexion une fois sur x, en partant respectivement de la fréquence (f_{ref}) de référence déterminée en dernier.

4. Procédé suivant l'une des revendications précédentes,
**caractérisé en ce que**, lors de la synchronisation pour la première fois, on utilise un signal (4) émis d'une station de base quelconque, mais on effectue l'établissement de connexion suivant sur une porteuse d'une autre station de base.

5. Procédé suivant la revendication 4,
**caractérisé en ce que** l'on utilise un élément mobile multimode unique pour la synchronisation du dispositif de communication mobile ayant des stations de base de standards différents, synchronisées entre elles.

6. Procédé suivant l'une des revendications précédentes,
**caractérisé en ce que** l'on effectue une mesure de température en plus d'un calibrage sur la plage de températures.
